(19) Europäisches Patentamt
European Patent Office
Office européen des brevets

(11) **EP 2 261 948 B1**

(12) **EUROPEAN PATENT SPECIFICATION**

(45) Date of publication and mention
of the grant of the patent:
**05.03.2014 Bulletin 2014/10**

(51) Int Cl.:
*H01J 37/32* (2006.01)   *C23C 14/00* (2006.01)
*C23C 14/08* (2006.01)   *C23C 14/34* (2006.01)
*H01J 37/34* (2006.01)   *H01L 41/316* (2013.01)

(21) Application number: **10183025.5**

(22) Date of filing: **27.09.2007**

(54) **Plasma discharge film-forming apparatus and method**

Plasmaentladungsanlage zur Schichterzeugung und entsprechendes Schichterzeugungsverfahren

Appareil de décharge à plasma pour formation d'un film et procédé de formation d'un film

(84) Designated Contracting States:
**CH DE FR GB LI NL**

(30) Priority: **28.09.2006 JP 2006263981**

(43) Date of publication of application:
**15.12.2010 Bulletin 2010/50**

(62) Document number(s) of the earlier application(s) in
accordance with Art. 76 EPC:
**07019053.3 / 1 906 433**

(73) Proprietor: **Fujifilm Corporation**
**Tokyo 1068620 (JP)**

(72) Inventor: **Fujii, Takamichi**
**Kanagawa-ken (JP)**

(74) Representative: **Vierheilig, Achim**
**Klunker Schmitt-Nilson Hirsch**
**Patentanwälte**
**Destouchesstrasse 68**
**80796 München (DE)**

(56) References cited:
**JP-A- 2005 272 941    US-A- 3 864 239**
**US-B1- 6 287 986**

**Description**

BACKGROUND OF THE INVENTION

Field of the Invention

This invention relates to a film-forming system according to claim 1. It also relates to a process of forming a film by a vapor phase growth method using plasma.

Description of the Related Art

As a method of forming film such as the piezoelectric film there has been known a method where the film is formed by a vapor phase growth method such as sputtering. Sputtering is a method of depositing the component element of a target onto the surface of the substrate by impacting plasma ions such as Ar ions at high energy generated by plasma discharge in high vacuum against the target to release the component elements of the target.

In order to formhigh quality film, it is necessary to optimize various film-forming conditions. For example, in the piezoelectric film comprising a Pb-containing perovskite oxide such as zircon titanate (PZT), Pb loss is apt to be generated when the piezoelectric film is formed at a high temperature. Accordingly, in the piezoelectric film comprising a Pb-containing perovskite oxide, it is necessary to obtain a film-forming condition under which a perovskite crystal less in the pyrochlore phase is better grown, and the Pb loss is less apt to be generated.

It is conceivable that the film quality also depends on the plasma conditions. As an example of a system for changing the plasma conditions, Japanese Unexamined Patent Publication No. 2000-290771 discloses a film-forming system where film is formed while controlling the potential of the plasma by the potential of the electrode which has been set to be in the same space as the plasma. In this film-forming system, the film quality is held not to deteriorate by giving ionized particles of the target component elements sufficient kinetic energy.

Further, in Japanese Unexamined Patent Publication No. 2005-272941, there is disclosed a film-forming system in which a shield insulated from a ground potential is disposed near the peripheral edge of the target. In this system, the plasma does flow into the shield from the end of the target, and the sputtering speed at the end of the target is held equivalent to that of the central portion. Further, in this system, another shield is overlapped on the shield by way of an insulator and the lower shield is protected from the sputtering.

Conventionally, it is believed that the film-forming temperature is about 550 to 700 °C is preferable in the piezoelectric film comprising a Pb-containing perovskite oxide such as PZT. However, these inventor's investigation has revealed that the perovskite crystal poor in the pyrochlore phase grows and a piezoelectric film exhibiting an excellent piezoelectricity can be obtained even when the film-forming temperature is about 420 to 480°C. Lower film-forming temperature is preferable in preventing the Pb loss.

Irrespective of whether it includes Pb, a stress is applied to the piezoelectric film in the cooling step during or after the film-forming step due to difference in the thermal expansion coefficient between the substrate and the piezoelectric film when the film-forming temperature is high and there is a fear that cracks or the like are generated in the film, whereby lower film-forming temperature is preferable. When the film can be formed at a lower temperature, the substrate may be of a glass or the like which is relatively low in thermal resistance, whereby width in selecting the substrate is increased, which is preferable.

It is conceivable that by controlling the plasma condition, high quality film can be formed without elevating the film-forming temperature. When, for instance, the film-forming pressure, is increased (the degree of vacuum is reduced), the particle energy of the target component elements released from the target deteriorates by the pressure increase, and the particle scatter increases, whereby the film-forming speed is reduced. Thus when one of film-forming conditions is changed, another unexpected parameter can change, which can affect the characteristics of the formed film. It is conceivable that the problem that even unexpected parameter can change can be overcome by controlling only the plasma conditions.

Though conforming to the present invention from the viewpoint of controlling the plasma, the invention disclosed in Japanese Unexamined Patent Publication No. 2000-290771 is different from the present invention in arrangement. That is, in the invention disclosed in Japanese Unexamined Patent Publication No. 2000-290771, the plasma is controlled by a plasma potential controlling power source and a plasma potential controlling electrode disposed between the target connected to the plasma potential controlling power source and a substrate. However, there is no disclosure on controlling the plasma by a shield as in the present invention.

Though mentioning to stain of a shield, that is a problem which is generated when the shield is stained with the elements released from the target, the invention disclosed in Japanese Unexamined Patent Publication No. 2005-272941 is different from the present invention in the means for overcoming the problem. That is, when the film of sputtering particles is peeled off the shield, it can adhere to the film-forming substrate as particles or impurities, and deteriorate the quality of the film. As the provision for this phenomenon, the invention disclosed in Japanese Unexamined Patent Publication No. 2005-272941 disposes another shield on the shield, the former shield being at a distance from the other edge of the target larger than the latter shield. With this arrangement, no film is generated on the lower shield, thereby preventing generation of particles due to peeling of the film and mixing of the particles (impurities) into the film.

US 3 864 239 A discloses a film-forming plasma apparatus having the vacuum chamber connected to a gas reservoir from which after the chamber has been evacuated, Ar gas is filled into the chamber. The gas reservoir and the vacuum system are connected to openings provided in the bottom of the chamber, the bottom being disposed beneath the substrate holder. The apparatus comprises a plurality of shields laminated with each other and spaced a part from one another, the shields being positioned near the cathode to confine the plasma to extend in the form of a column in the direction of the anode.

SUMMARY OF THE INVENTION

In view of the foregoing observations and description, the primary object of the present invention is to provide a film-forming system and a film-forming process which can optimize the plasma conditions, and form high q1uality insulating film or the like having desired characteristics.

Still another object of the present invention is to provide insulating film, dielectric film, piezoelectric film, and ferroelectric film having a high q1uality described above.

The film forming system of the present invention comprises the features of claim 1.

Preferred embodiments are defined by the dependent claims.

The shield may be grounded. The shield may be electrically insulated from the target and the wall of the vacuum chamber while a voltage may be imparted thereon.

Specifically, a dimension L of the shield in a direction perpendicular to a laminating direction (in which the shield is laminated) is not smaller than a distance S between the shield layers in the laminating direction ($L \geq S$).

The film-forming process of the present invention is **characterized** by the features of claim 6.

The film-forming process of the present invention is applicable when film is formed by a vapor phase growth method using plasma. As the film to which the film-forming process of the present invention is applicable, an insulating film, a dielectric film, a piezoelectric film, and the like can be shown.

The film-forming process of the present invention is suitably applicable to film comprising one kind or more kinds of perovskite oxides (may include an unavoidable impurity). The piezoelectric film comprising a perovskite oxide is a ferrodielectric film which exhibits spontaneous polarization when no-voltage is imparted thereto.

By adjusting the height of shield, a film can be formed with the difference Vs-Vf (V) between the plasma potential Vs (v) and the floating potential Vf (V) controlled.

It is preferred that the piezoelectric film be formed with the difference Vs-Vf (V) between the plasma potential Vs (v) and the floating potential Vf (V) held not larger than 35eV and the temperature of the substrate not lower than 400°C.

In this specification, the "film-forming temperature Ts (°C)" means a temperature at the center of the substrate on which the film is to be formed.

In this specification, "the plasma potential Vs (v) and the floating potential Vf (V) during the film-forming" are measured by single probe method by the use of a Langmuir probe. The floating potential Vf is measured in a possible shortest time with the tip of the probe positioned near the substrate (about 10mm from the substrate) so that the probe does not include an error due to film in forming adhering to the probe.

The difference Vs-Vf (V) between the plasma potential Vs (v) and the floating potential Vf (V) can be converted to the electron temperature (eV). The electron temperature 1eV corresponds to 11600K (K is the absolute temperature).

Since the film-forming system of the present invention is provided with a shield, the state of potential in the plasma space can be adjusted due to existence of the shield and be optimized. In the system of the present invention, the difference Vs-Vf (V) between the plasma potential Vs (v) and the floating potential Vf (V) can be optimized by the shield, whereby high quality film can be formed. The film-forming system of the present invention can be suitably used especially in formation of an insulating film such as piezoelectric film.

The shield comprises a plurality of shield layers laminated with each other intervening therebetween a space which permits the film-forming gas to pass therethrough. The difference Vs-Vf (V) between the plasma potential Vs (v) and the floating potential Vf (V) can be controlled by changing the number of the shield layers to change the height of the shield.

The shield provided in the film-forming system of the present invention has a space which permits the film-forming gas to pass therethrough. Accordingly, the film-forming gas is apt to pass through the space in the shield to reach the plasma space, whereby the gas ions turned to plasma in the vicinity of the target can easily reach the target and the elements of the target can be efficiently released. It is conceivable that high q1uality film having desired characteristics can be stably formed as a result.

When the shield is grounded, it is conceivable that spread of the plasma is suppressed by the shield, and the difference Vs-Vf (V) between the plasma potential Vs (v) and the floating potential Vf (V) can be efficiently reduced as a result.

The shield may be electrically insulated from the target and the wall of the vacuum chamber while a voltage may be imparted thereon. In this case, the difference Vs-Vf (V) between the plasma potential Vs (v) and the floating potential Vf (V) can be controlled by adjusting the voltage.

Since the shield provided in the film-forming system of the present invention has a space which permits the film-forming gas to pass therethrough, the state of potential of the shield cannot be changed by the deposited particles (comprising elements released from the target) adhering to the entire shield. Accordingly, the shield is stable in its function even after repeated use and the difference Vs-Vf (V) between the plasma potential Vs (v) and the floating potential Vf (V) can be stably held.

A dimension L of the wall of the shield in a direction perpendicular to a laminating direction (in which the shield is laminated) is not smaller than a distance S between the shield layers in the laminating direction (L≥S). With this arrangement, the probability that the deposited particles adheres to the shield layer farther to the target is weak even if the deposited particles adheres to the inner peripheral surface of the shield layer nearer to the target whereby the state of potential of the shield can be effectively prevented from being changed by adhesion of the deposited particles to the shield since the shield layers are wide in the depth as seen from the deposited particles and limits entrance of the deposited particles.

Even the shield with a space forms a barrier of equipotential on the inner peripheral side similarly to the shield without a space, accordingly, the Vs-Vf adjusting effectiveness of the shield with a space is on a level equivalent to the shield without a space.

In accordance with the film-forming process of the present invention, the state of potential of the shield, that is, the difference Vs-Vf (V) between the plasma potential Vs (v) and the floating potential Vf (V) can be adjusted and optimized by a shield comprising a changeable number of shield layers, which surrounds the outer peripheral surface of the target facing the substrate, whereby high quality film can be formed.

In the case where the potential difference Vs-Vf (V) is adjusted by the height of the shield, the potential difference Vs-Vf (V) can be easily adjusted.

Further, when the difference Vs-Vf (V) between the plasma potential Vs (v) and the floating potential Vf (V) is not larger than 35eV and the substrate temperature is not lower than 400°C, piezoelectric film having desired performance can be formed.

An insulating film, a dielectric film, a piezoelectric film, a ferroelectric film are excellent in quality since they are formed in accordance with the film-forming process of the present invention.

Further, a piezoelectric element using an above mentioned piezoelectric film is of a desired performance and a liquid discharge system using this piezoelectric element is of a desired performance.

Since the film-forming system of the present invention is provided with a shield which surrounds the outer peripheral surface of the target holder facing the substrate, the difference Vs-Vf (V) between the plasma potential Vs (v) and the floating potential Vf (V) can be adjusted and optimized by the shield, whereby high quality film can be formed.

BRIEF DESCRIPTION OF THE DRAWINGS

Figure 1A is a cross-sectional view showing an RF sputtering system,
Figure 1B is a schematic view showing formation of film,
Figure 2 is an enlarged view of the shield and the vicinity thereof shown in Figures 1A and 1B,
Figure 3 is a view showing an example of a method of measuring plasma potential and the floating potential,
Figure 4 is a cross-sectional view showing the film-forming system in accordance the second embodiment of the present invention where the control voltage can be imparted to the shield,
Figure 5 is a view showing the structure of a piezoelectric element and an ink jet recording head,
Figure 6 is an example of the structure of the ink jet recording system provided with the ink jet recording head shown in Figure 5,
Figure 7 is a fragmentary plan view showing a part of the ink jet recording system shown in Figure 6, and
Figure 8 is a view showing the result of embodiment 1 (the relation between the number of rings and the difference between the plasma potential and the floating potential.

DESCRIPTION OF THE PREFERRED EMBODIMENT

[System for forming film]

(First embodiment)

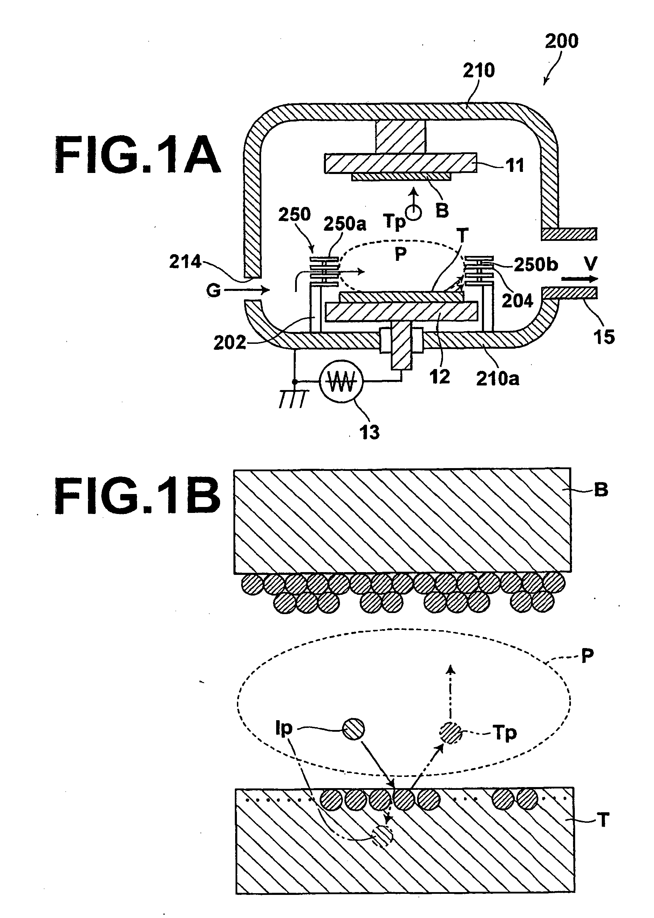

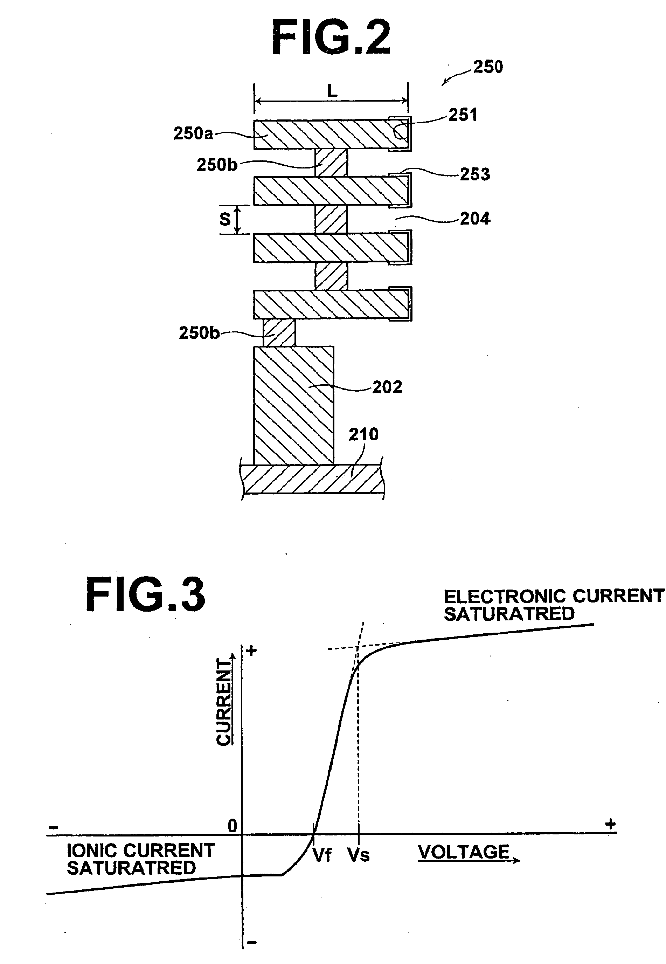

A first film forming system of the present invention will be described with reference to Figures 1A, 1B and 2, hereinbelow. In this embodiment, an RF sputtering system as a film-forming system using plasma will be described with reference to Figures 1A and 1B by way example. Figure 1A is a cross-sectional view showing in brief an RF sputtering system, and Figure 1B is a schematic view showing formation of film. Figure 2 is an enlarged view of the shield and the vicinity thereof shown in Figures 1A and 1B.

As shown in Figure 1A, the film-forming system 200 briefly comprises a vacuum chamber 210 having therein a substrate holder 11 such as an electromagnetic chuck which holds a substrate (film-forming substrate) B and can heat the substrate B to a predetermined temperature and a plasma electrode (cathode electrode) 12 which generates plasma. The plasma electrode 12 corresponds to the target holder which holds a target T.

The substrate holder 11 and the plasma electrode 12 are spaced from each other so that they are opposed to each other and a target T having a composition according to the composition of the film to be formed is mounted on the plasma electrode 12. The plasma electrode 12 is connected to a high frequency power source 13. The plasma electrode 12 and the high frequency power source 13 will be referred to as "plasma generating portion", hereinbelow. A shield 250 which surrounds the outer peripheral surface of the target T facing the substrate. In other words, a shield 250 which surrounds the outer peripheral surface of the target holder facing the substrate.

A gas introduction tube 214 which introduces gas G necessary to form the film into the vacuum chamber 210 and a gas discharge tube 15 which discharge (V) the gas in the vacuum chamber 210 are mounted on the vacuum chamber 210. The gas introduction tube 214 is disposed opposite to the gas discharge tube 15 at about the same height as the shield 250.

As the gas G, Ar gas or a $Ar/O_2$ gas mixture or the like is employed. As schematically shown in Figure 1B, the gas G introduced into the vacuum chamber 10 is turned to plasma in response to discharge of the plasma electrode 12 and plus ions Ip such as Ar ions are generated. The generated plus ions Ip sputter the target T. The elements Tp of the target T sputtered by the plus ions Ip are released from the target and deposited on the substrate B in a neutral state or an ionized state. In the drawings, P denotes a plasma space.

The potential of the plasma space P makes a plasma potential Vs (V) during film-forming. The substrate B is normally an insulator and electrically insulated from the ground. Accordingly, the substrate B is in a floating state and the potential thereof makes a floating potential Vf (V). It is conceivable that the elements Tp of the target which are between the target T and the substrate B impact against the substrate B in forming film with kinetic energy corresponding to an acceleration of a potential difference Vs-Vf (V) between the potential of the plasma space P and the potential of the substrate B.

In the vapor phase growth method using plasma, as factors which affect the characteristics of the film to be formed, the film-forming temperature, the kind of the substrate, the composition of the under-film if there is film formed previously, the surface energy of the substrate, the film-forming pressure, the amount of oxygen in the environmental gas, the thrown electrode, the substrate-target distance, the temperature and density of the electrons in the plasma, or the density and life of the active elements in the plasma is conceivable. These inventor's have found that in the factors, the characteristics of the film to be formed largely depends upon the film-forming temperature Ts (°C) and the difference Vs-Vf (V) between the plasma potential Vs (v) and the floating potential Vf (V), and high quality film can be formed by optimizing these factors.

The film to which the film-forming process of the present invention is applicable, an insulating film, a dielectric film, a piezoelectric film, and the like can be shown. The film-forming process of the present invention is suitably applicable to film comprising one kind or more kinds of perovskite oxides (may include an unavoidable impurity). The piezoelectric film comprising a perovskite oxide is a ferrodielectric film which exhibits spontaneous polarization when no-voltage is imparted thereto.

The plasma potential Vs and the floating potential Vf can be measured by the use of a Langmuir probe. When the tip of the Langmuir probe is inserted into the plasma space P and the voltage applied to the probe is changed, the current-voltage characteristics such as shown in Figure 3 can be obtained ("Fundamental of the plasma and Film-forming" byMitsuharu Onuma, p. 90, Nikkan Kougyou Shinbun) .

In this drawing, the probe potential where the current is 0 is the floating potential Vf. This state is obtained when the amount of ionic current flowing into the probe surface is equalized to the amount of electronic current flowing into the probe surface. The surface of an insulated metal or an insulated substrate is at this potential. As the probe potential is increased above the floating potential Vf, the ionic current gradually reduces and finally only electronic current reaches the probe. The border voltage makes the plasma potential Vs.

That Vs-Vf relates to the kinetic energy of the elements Tp of the target T impacting against the substrate B has been described above. The kinetic energy E is generally represented by a function of the temperature T as shown by the following formula. Accordingly, it is conceivable that the Vs-Vf has the same effect as the temperature to the substrate B.

$$E = 1/2mv^2 = 3/2kT$$

wherein m, v, k and T respectively represent a mass, a velocity, a constant and an absolute temperature. It is conceivable that the Vs-Vf has effects of promoting the surface migration and of etching weakly bonded portions in addition to the same effect as the temperature.

The vacuum chamber 210 shown in Figure 1A is **characterized in that** the shield 250 which surrounds the outer peripheral surface of target T facing the substrate B is disposed inside the vacuum chamber 210. This shield 250 is disposed on a ground shield or a grounded member 202 erected on a bottom surface 210a of the vacuum chamber 210 to surround the outer peripheral surface of target T facing the substrate B. The grounded member 202 is for preventing the plasma electrode 12 from discharging laterally or downwardly to the vacuum chamber 210.

The vacuum chamber 210 comprises a plurality of annular metal plates or rings (fins, shield layers) 250a, as an example, as shown in Figures 1A and 2. The rings 250a is four in the illustrated embodiment, and a conductive spacer 250b is disposed each between adjacent rings 250a. The spacers 250b are disposed with spaces in the circumferential direction of the rings 250a and forms a space 204 between adjacent spacers 250b so that gas G is apt to flow therethrough. From this viewpoint, it is preferred that the spacer 250b be disposed also between the grounded member 202 and the ring 250a placed immediately thereon.

In the above arrangement, the shield 250 is electrically connected to the grounded member 202 to be grounded. The ring 250a and the spacer 250b may be made in any material though preferably they are made in SUS (stainless steel) or the like.

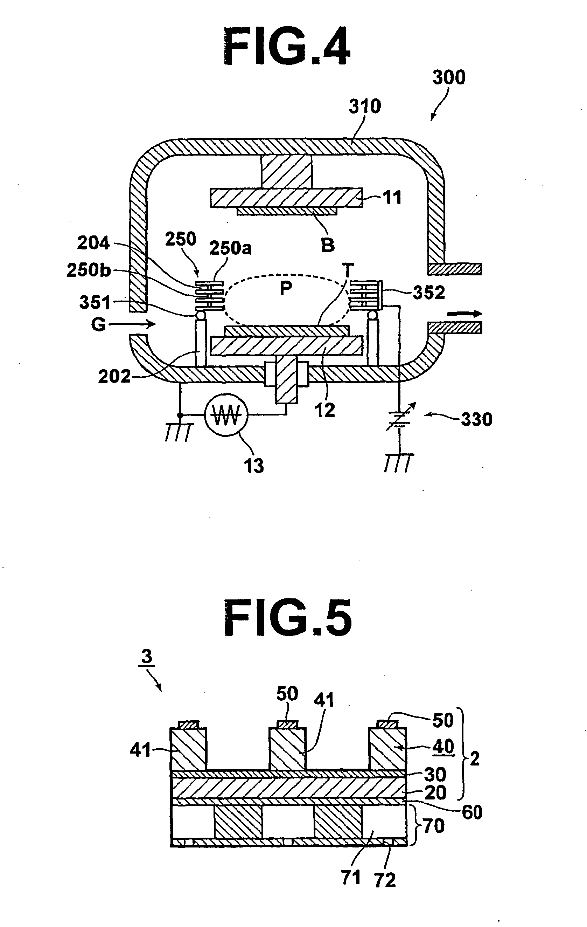

A conductive member (not shown, the same as the conductive member 352 of the second embodiment shown in Figure 4) which electrically connects the plurality of rings 250a may be mounted on the outer periphery of the shield 250. Though since adjacent rings 250a of the shield 250 are conductive by way of conductivity of the spacer 250b and the rings 250a may be grounded only by way of conductivity of the spacer 250b, the plurality of rings 250a are easy to be grounded by providing additional conductive member.

Since the shield 250 is disposed to surround the outer peripheral surface of target T facing the substrate B as described above, a grounded potential is formed on the outer peripheral surface of target T facing the substrate B by the shield 250.

In this embodiment, by the shield 250 having structure described above, the plasma condition can be adjusted and optimized, whereby the difference Vs-Vf (V) between the plasma potential Vs (v) and the floating potential Vf (V) can be adjusted and optimized.

The reason for this is conceivable as follows.

When a voltage from the high frequency power source 13 is applied to the plasma electrode 12 in order to form film on the substrate B, plasma is generated above the target T and at the same time, electric discharge is generated between the shield 250 and the target T. It is conceivable that the plasma is confined in the shield 250 and the plasma potential is lowered to lower the difference Vs-Vf (V) between the plasma potential Vs (v) and the floating potential Vf (V), by this discharge. When the difference Vs-Vf (V) between the plasma potential Vs (v) and the floating potential Vf (V) lowers, the energy at which the elements Tp released from the target T impact against the substrate B deteriorates. By optimizing the difference Vs-Vf (V) between the plasma potential Vs (v) and the floating potential Vf (V), the particle energy of the elements Tp of the target T can be optimized and high quality film can be formed.

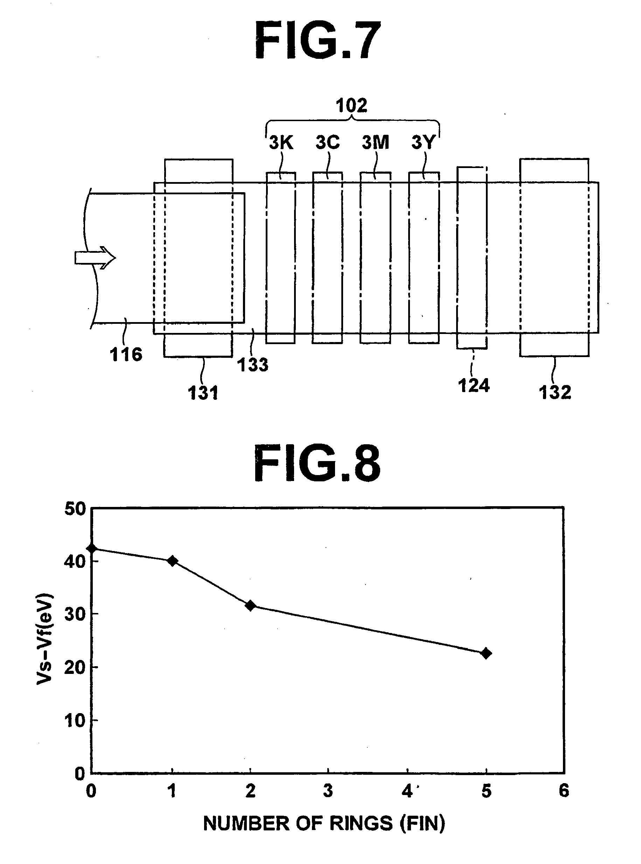

The difference Vs-Vf (V) between the plasma potential Vs (v) and the floating potential Vf (V) tends to lower, as the number of the rings 250a increases and the height of the entire shield 250 increases. (See, Figure 8 of the embodiment 1 described later.) This is conceivable because as the height of the entire shield 250 increases, the discharge between the shield 250 and the target T is strengthened, and the difference Vs-Vf (V) between the plasma potential Vs (v) and the floating potential Vf (V) is lowered.

A particular film-forming temperature governs Vs-Vf (V) under which the best film-forming conditions can be obtained. In order to obtain the most preferred potential difference, it is possible to adjust the potential difference to a desired potential difference by increasing and decreasing the number of the rings 250a with the film-forming temperature kept unchanged. Since the rings 250a are simply laminated by way of the spacers 250b as shield layers, the number of the rings 250a can be changed by removing one or more of the rings 250a.

The lowermost ring 250a in the shield 250 is spaced from the outer periphery of the target T. Since the electrical discharge cannot be generated when the distance by which the target T and the shield 250 are spaced from each other is 0, and the effectiveness of the shield can be weakened, when the distance is too large, the space is preferably 1 to 30mm.

The component elements Tp of the target T released from the target T adheres to the rings 250a of the shield 250 disposed near the target T as well as the substrate B. The largest amount of component elements Tp of the target T adheres to the edge 251 of the inner periphery of the rings 250a facing the target T and the vicinity thereof. This state is shown. As shown in Figure 2, film 253 is formed by the particles of component elements Tp (deposited particles) adhering to the edge 251 of the inner periphery of the rings 250a and upper and lower surfaces of the ring 250a in the vicinity thereof. When the film 253 is formed over the entire area of each ring 250a, the function of the shield 250 as the grounded potential is damaged, and accordingly, it is preferred that the shield 250 be formed so that the film 253 is difficult to adhere as difficult as possible.

In this embodiment, since the shield 250 comprises a plurality of rings 250a vertically laminated with each other intervening therebetween the space 204, the deposited particles comprising the particles of component elements Tp released from the target is prevented from adhering to the entire shield 250 to change the potential state of the shield 250. Accordingly, the shield 250 stably functions even after repeated use and the difference Vs-Vf between the plasma potential Vs and the floating potential Vf can be stably held.

It is especially preferred that a dimension L of the shield in a direction perpendicular to a laminating direction (in which the shield is laminated) be not smaller than a distance S between rings 250a or shield layers adjacent to each other in the laminating direction ($L \geq S$). With this arrangement, the dimension L of the ring 250a is widened to a predetermined range with respect to the distance S between rings 250a and is effective in preventing film 253 from adhering to the entire rings 250a whereby the state where the shield 250 is out of function in a short time can be avoided by widening the rings 250a in the depth as seen from the deposited particles and limits entrance of the component elements Tp into the outer periphery of the space 204.

Other effects can be expected to the space 204. That is, since the space 204 functions as the passage for the film-forming gas G, the film-forming gas G is apt to reach the plasma space near the target T through the spaces 204 of the shield 250 and as a result, the gas ions turned to the plasma in the vicinity of the target T can easily reach the target T, whereby the component elements Tp of the target T can be effectively released from the target T. It is conceivable that high quality film having desired characteristics can be stably formed as a result.

Since a shield 250 with a space forms a barrier of equipotential on the inner peripheral side similarly to the shield without a space, accordingly, the Vs-Vf adjusting effectiveness of the shield with a space is on a level equivalent to the shield without a space.

Though in Japanese Unexamined Patent Publication No. 2005-272941, there is disclosed a shield of structure where a plurality of shield layers are laminated by way of insulators, no space is provided between shield layers in Japanese Unexamined Patent Publication No. 2005-272941.

The film-forming system 200 of this embodiment is suitably applicable in forming insulating film such as a piezoelectric film or the like. These inventors have found that it is preferred that the piezoelectric film be formed with the difference Vs-Vf (V) between the plasma potential Vs (v) and the floating potential Vf (V) held not larger than 35eV and the temperature of the substrate not lower than 400°C. By forming film under such film-forming conditions, high quality film having desired characteristics can be formed.

Since in this embodiment as described above, the film-forming system 200 of the present invention is provided with a shield 250 which surrounds the outer peripheral surface of the plasma electrode 12 holding the target T, that is, the target holder, facing the substrate and has a space 204 for passing through the film-forming gas G, the state of potential in the plasma space can be adjusted due to existence of the shield 250 and be optimized. In the film-forming system 200 of the this embodiment, the difference Vs-Vf (V) between the plasma potential Vs (v) and the floating potential Vf (V) can be optimized by the shield 250.

It is conceivable that since the shield 250 is grounded in this embodiment, spread of the plasma is suppressed by the shield 250, and the difference Vs-Vf (V) between the plasma potential Vs (v) and the floating potential Vf (V) can be reduced as a result.

By the use of the film-forming system 200 of this embodiment, the difference Vs-Vf (V) between the plasma potential Vs (v) and the floating potential Vf (V) can be adjusted and optimized, whereby high quality film can be formed. In this embodiment, the potential difference Vs-Vf (V) can be easily adjusted by changing the number of the rings 250a to change the height of the shield 250.

In this embodiment, the potential difference Vs-Vf (V) can be adjusted by changing the height of the shield 250. The Vs-Vf can adjusted also by changing the film-forming pressure, the power thrown to the target, and the like. However, when the Vs-Vf is to be controlled by changing the film-forming pressure, the power thrown to the target, and the like, there is a fear that other parameters such as the film-forming speed can change and the desired quality of film cannot be obtained. These inventors' experiment under certain condition says that the film-forming speed was lowered from $4\mu$m/h to $2\mu$m/h though the Vs-Vf could be reduced from 38eV to 25eV when the power thrown to the target is changed from 700W to 300W. In the system 200 of this embodiment, since the Vs-Vf can be controlled without changing other parameters such as the film-forming speed, it is easy to optimize the film-forming condition and high quality film can be formed.

(Second embodiment)

Though, in the embodiment described above, the shield 250 is grounded, the shield 250 may be insulated and applied with a bias voltage. This second embodiment will be described with reference to Figure 4.

A film-forming system 300 of this embodiment is shown in Figure 4 basically the same as the first embodiment except that the shield 250 can be applied with a control voltage. Accordingly, the elements analogous to those in the film-forming system 200 shown in Figure 1A will be given the same reference numerals and will not be described.

In this second embodiment, the shield 250 is electrically insulated from the grounded member 202 by way of insulator porcelains 351. The insulator porcelains 351 are similar to the above described spacer 250b, and are disposed in a plurality of sites but differ from the spacer 250b in that the former are insulators. The rings 250a of the shield 250 are laminated together by way of the conductive spacers 250b as in the first embodiment.

On the outer periphery of the shield 250, is mounted a conductive member 352 which conducts electricity through a plurality of rings 250a. Since the rings 250a of the shield 250 are made conductive with each other by the conductive spacer 250b, the conductive member 352 is not essential but by additionally mounting the conductive member 352 on the outer periphery of the shield 250, an external application of a voltage to the shield is facilitated. The conductive member 352 may be any suitable member and, for instance, a strip-like foil of aluminum.

This shield 250 is electrically connected to a power source 330 for control which is disposed externally of the vacuum chamber 310. This power source 330 can apply to the shield 250 either positive (+) side or negative (-) side voltage with respect to the potential of the vacuum chamber 310 or the grounded potential. When a positive voltage is applied to the shield 250, the potential in the plasma space P increases, and when a negative voltage is applied to the shield 250, the potential in the plasma space P decreases. That is, in this embodiment, the difference Vs-Vf (V) between the plasma potential Vs (v) and the floating potential Vf (V) can be controlled by the shield 250.

Though the present invention has been described in detail with respect to the embodiments, the present invention need not be limited to the embodiments but may be variously changed. For example, the shield 250 may be of a structure integrated as if a plurality of annular plate rings are laminated in addition to the structure where a plurality of separate annular plate rings are laminated to form layers as in the embodiments described above. Further, a structure may be employed where rings are made from a plurality of linear members and the rings are laminated together by way of a spacer. Further, a structure may be employed where a plurality of linear members may be helical and a spacer may intervene between the linear members each of which forms one-turn of the helicoid. In this case, one-turn of the helicoid makes a shield layer. Further, a structure may be employed where a cylindrical shield is provided with spaces each of which extends along the circumference of the cylinder layered in the vertical direction. In any of the modifications, the shield 250 has a space and the space facilitates flow of introduced gas G. Further, in these modifications, also the existence of the space limits adhesion of the deposited particles to the shield, and prevents the shield from being covered with the film and deteriorating in its function in a short time.

The shield need not be circular, but may be of any suitable shape such as a rectangle, a polygon, or a ellipsoid according to the shape of the target.

[Method of forming piezoelectric film]

The film-forming systems 200 and 300 in accordance with the first and second embodiments are suitably applicable to piezoelectric film comprising at least one kind of perovskite oxide (may include an unavoidable impurity) represented by the following general formula (P).

$$A_aB_bO_3 \qquad (P)$$

(wherein A represents at least one kind of elements forming the A site including Pb, B represents at least one kind of elements forming the B site including an element selected from an element group consisting of Ti, Zr, V, Nb, Ta, Cr, Mo, W, Mn, Sc, Co, Cu, In, Sn, Ga, Zn, Cd, Fe, Ni, and lanthanide elements, O represents an oxygen atom and a and b may deviate from 1.0 in the range where perovskite structure is held though a=1.0, b=1.0 by standard.)

As perovskite oxide represented by the above general formula (P), lead-containing compounds such as lead titanate, zircon lead titanate (PZT), lead zirconate, lead titanate lanthanum, lead titanate lanthanum zirconate, magnesium niobate zircon lead titanate, and nickel niobate zircon lead titanate and non-lead-containing compounds such as barium titanate, bismuth sodium titanate, bismuth potassium titanate, sodium niobate, potassium niobate, and lithium niobate can be shown. The piezoelectric film may be have a mixed crystal of these perovskite oxide. These piezoelectric materials is a ferrodielectric body which exhibits spontaneous polarization when no-voltage is imparted thereto.

The piezoelectric film-forming systems 200 and 300 of the embodiments described above are suitably applicable to PZT represented by the following general formula (P-1) or B-site-substituted compounds thereof and compounds having a mixed crystal of these compounds.

$$Pb_a(Zr_{b1}Ti_{b2}X_{b3})O_3 \qquad (P-1)$$

(wherein X represents at least one kind of metal element selected from an element group consisting of the V and VI group elements, and a>0, b1>0, b2>0, b3>0. Though a=1.0 and b1+b2+b3=1.0 by standard, these values may deviate from 1.0 in the range where perovskite structure is held.)

The perovskite oxide represented by the general formula (P-1) is zircon lead titanate (PZT) when d=0, and is an oxide where a part of B-site of the PZT is substituted for by X which is at least one kind of metal element selected from an element group consisting of the V and VI group elements when d>0.

X may be anyone of metal elements of VA, VB, VIA, VIB group elements, and preferably at least one kind of metal element selected from an element group consisting of V, Nb, Ta, Cr, Mo and W.

These inventor's have revealed that it is preferred that when piezoelectric film comprising the perovskite oxide represented by the general formula P is to be formed, the film-forming condition be determined to satisfy the following formulae (1) and (2).

$$Ts(°C) \geq 400 \quad \cdots \quad (1)$$

$$-0.2Ts+100 < Vs-Vf)(V) < -0.2Ts+130 \quad \cdots \quad (2)$$

These inventor's have revealed that when piezoelectric film comprising the perovskite oxide represented by the general formula P is to be formed, a perovskite crystal is not grown well and film which is of a pyrochlore phase in main is formed under the film-forming condition, Ts(°C)<400, where the formula (1) is not satisfied.

These inventor's have further revealed that when piezoelectric film comprising the perovskite oxide represented by the general formula P is to be formed, a perovskite crystal which is less in a pyrochlore phase can be stably grown and the Pb loss can be stably suppressed, whereby piezoelectric film which is of a high quality in crystalline structure and film composition can be stably formed by determining the film-forming condition so that the film-forming temperature Ts and the Vs-Vf satisfy the above formula (2) when 400≤Ts(°C) and the above formula (1) is satisfied.

It has been known that the Pb loss is apt to occur when the piezoelectric film is formed at a high temperature in the sputtering. These inventor's have further revealed that the Pb loss depends upon the Vs-Vf in addition to the film-forming temperature. In Pb, Zr and Ti forming the PZT, Pb is the most in the sputtering ratio, and is the most apt to be sputtered. For example, table 8. 1 7 of "Vacuum Handbook" edited by Ulvac Inc. and published by Ω Inc., discloses that the sputtering ratio at 300ev of Ar ions are Pb=0.75, Zr=0.48 and Ti=0.65. That a substance is apt to be sputtered is that the sputtered atom of the substance is apt to be sputtered again after adhering to the surface of the substrate. It is conceivable that as the difference between the plasma potential and the substrate potential increases that is, Vs-Vf increases, the sputtering ratio increases and the Pb loss is more apt to be generated. This is real in Pb-containing perovskite oxides other than PZT. Further, this is real in a vapor phase growth method using plasma other than sputtering.

Under the condition where the film-forming temperature TS is too low and the Vs-Vf is too small, a perovskite crystal tends to be not grown well. Under the condition where least one of the film-forming temperature TS and the Vs-Vf is too large, the PB loss tends to be apt to be generated.

When 400≤TS (°C) and the above formula (1) is satisfied, it is necessary to relatively raise the Vs-Vf in order to better grow the perovskite crystal when the film-forming temperature Ts is relatively low and it is necessary to relatively reduce the Vs-Vf in order to suppress the Pb loss when the film-forming temperature Ts is relatively high. This is represented by the above formula (2) .

These inventors have found that when piezoelectric film comprising the perovskite oxide represented by the general formula P is to be formed, piezoelectric film high in the piezoelectric constant can be formed by determining the film-forming condition so that the following formula (1) to (3) are satisfied.

$$Ts(°C) \geq 400 \quad \cdots \quad (1)$$

$$-0.2Ts+100 < Vs-Vf)(V) < -0.2Ts+130 \quad \cdots \quad (2)$$

$$10 \leq Vs-Vf) (V) \leq 35 \quad \cdots \quad (3)$$

These inventor's have found that when the above piezoelectric film comprising the perovskite oxide represented by the general formula P is to be formed, the obtained film has a low piezoelectric constant $d_{31}$ of 100Pm/V or so though perovskite crystals which are less in the Pb loss can be grown when the Vs-Vf is controlled to about 42 under the film-forming condition where the film-forming temperature Ts is about 420. Under these conditions, it is conceivable that since Vs-Vf, that is, the energy of the elements Tp of the target T impacting against the substrate B, is too high, defect is apt to be generated in the film and the piezoelectric constant gets low. These inventor's have found that when the film-forming condition is determined to satisfy the above formulae (1) to (3), the obtained film has piezoelectric constant $d_{31}$ of not than 130Pm/V.

When piezoelectric film is to be formed, by using a film-forming system 200 or 300 of above embodiment, and determining the film-forming condition so that the film-forming temperature Ts and the Vs-Vf satisfy the above formulae (1) and (2), preferably (1) to (3), perovskite crystals which are less in the pyrochlore phase can be stably grown and the loss of Pb can be stably suppressed. When the film-forming condition is determined so that the film-forming temperature Ts and the Vs-Vf satisfy the above formulae (1) and (2), preferably (1) to (3), piezoelectric films having a composition in which $1.0 \leq a$ which are free from the loss of Pb can be provided and piezoelectric films having a composition in which $1.0 < a$ and Pb is enriched can be provided. The upper limit of a is not limited and these inventor's have found that when a is in the range of $1.0 \leq a \leq 1.3$, piezoelectric film having an excellent performance can be formed.

[Piezoelectric element and ink jet recording head]

Structure of the piezoelectric element obtained by the process of the present invention, and the ink jet recording head (liquid discharge system) which are provided with the piezoelectric element will be described with reference to Figure 5. Figure 5 is a cross-sectional view (cross-sectional view in the direction of thickness of the piezoelectric element) of an important part of the ink jet recording head. For the purpose of easiness in viewing, the components are depicted in suitable scales different from the real scales.

The piezoelectric element 2 comprises a lower electrode 30, piezoelectric film 40 and an upper electrode 50 superposed one on another on a substrate 20 in sequence. To the piezoelectric film 40, the electric field is applied in the direction of thickness by the lower and upper electrodes 30 and 50.

The lower electrode 30 is formed over substantially the entire area of the substrate 20, and on the lower electrode 30, is formed the piezoelectric film 40 where the line protrusions 41 each of which extends from this side of Figure 5 to the other side of the lower electrode 30 are arranged in a stripe pattern, and the upper electrode 50 is formed on each of the protrusions 41.

The pattern of the piezoelectric film 40 need not be limited to the illustrated pattern but may be suitably designed. The piezoelectric film 40 may be continuous. However, it is preferred that the piezoelectric film 40 be formed in a pattern of a plurality of the separate protrusions 41 so that expansion and contraction of each protrusion take place smoothly and a larger displacement can be obtained.

The substrate 20 may be basically formed of any material such as silicon, glass, stainless steel (SUS), yttrium-stabilized zirconia (YSZ), alumina, sapphire, silicon carbide, and the like. The substrate 20 may even comprise, a laminated circuit board such as an SOI board where $SiO_2$ oxide film is superposed on the surface of a silicon substrate.

The main component of the lower electrode 30 may basically comprises any material such as metal and metal oxide like Au, Pt, Ir, $IRO_2$, $RuO_2$, $LaNiO_3$ and $SrRuO_3$ and combinations thereof.

The main component of the upper electrode 50 may basically comprises any material such as electrode materials generally used in a semiconductor process like materials shown by way of example in the lower electrode 30, Al, Ta, Cr and Cu and combinations thereof.

The piezoelectric film 40 is piezoelectric film formed by the piezoelectric film-forming process of the present invention described above. Preferably, the piezoelectric film 40 comprises perovskite oxide represented by the above general formula (P).

The thickness of the lower and upper electrodes 30 and 50 basically need not be limited, and, for instance, about 200nm. The thickness of the piezoelectric film 40 basically need not be limited, and normally not smaller than $1 \mu m$ and, for instance, 1 to 5 $\mu m$.

The ink jet recording head 3 substantially comprises an ink nozzle (liquid storing/dischargingmember) 70 which is provided with ink chambers (a liquid storing chamber) 71 for storing therein ink and an ink discharge port (liquid discharge port) 72 through which ink is externally discharged from the ink chamber 71 and is mounted on the lower surface of the substrate 20 of the piezoelectric element 2 by way of the vibrating plate 60. The ink chambers 71 are provided in a plurality corresponding to the number and the pattern of the protrusion 41 of the piezoelectric film 40.

In the ink jet recording head 3, the intensity of the electric field applied to the protrusions 41 of the piezoelectric element 2 is increased or reduced by the protrusions 41 thereby expanding or contracting the protrusions 41 to control the discharge of the ink from the ink chamber 71.

The piezoelectric element 2 and the ink jet recording head 3 are structured as described above.

(Ink jet recording system)

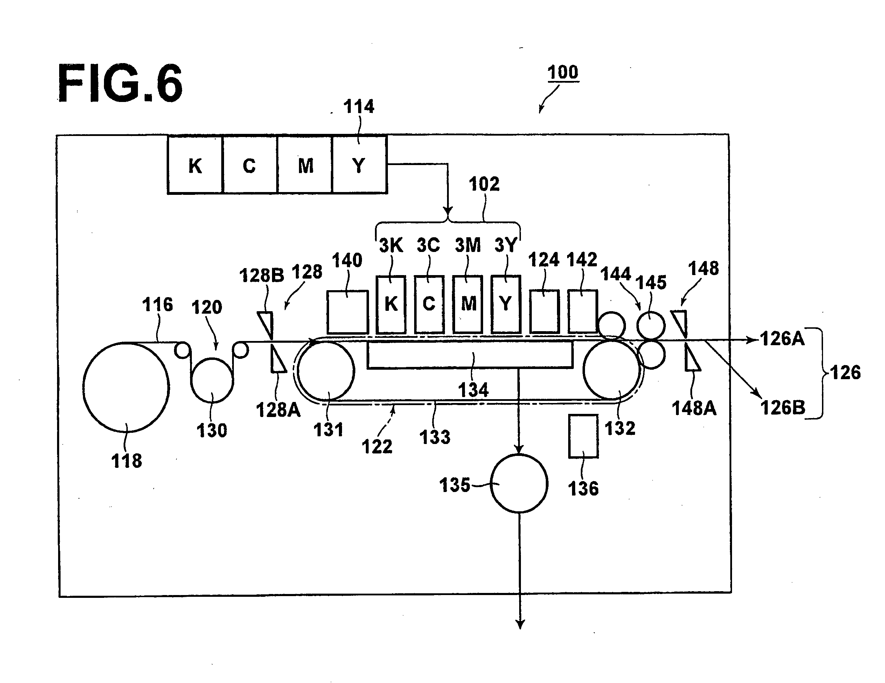

An example of an ink jet recording system provided with an ink jet recording head 3 as described above will be described with reference to Figures 6 and 7. Figure 6 shows the overall ink jet recording system, and Figure 7 shows a part of the ink jet recording system.

The ink jet recording system 100 comprises a printing portion 102 having ink jet recording heads 3K, 3C, 3M and 3Y provided for each color of ink, an ink storing/loading portion 114 for storing ink to be supplied to heads 3K, 3C, 3M and 3Y, a paper supply portion 118 for supplying recording papers 116, a decurl portion 120 which removes the curl from the recording papers 116, a suction belt transfer portion 122 which is opposed to a nozzle surface (through which the ink is discharged) of the printing portion 102 and transfers the recording paper 116 while holding the flatness of the recording paper 116, a print detecting portion 124 which detects result of printing by the printing portion 102 and a paper discharge portion 126 which externally discharges printed recording paper (printings).

Each of the heads 3K, 3C, 3M and 3Y forming the printing portion 102 is an ink jet recording head 3 as described above.

In the decurl portion 120, heat is applied by the heating drum 130 to the recording paper 116 in the direction reverse to the direction in which the recording paper 116 tends to curl, and the recording paper 116 is decurled.

In the system using a rolled paper, a cutter 128 is provided in the stage behind the decurl portion 120 to cut the rolled paper into a desired size as shown in Figure 6. The cutter 128 comprises a stationary blade 128A having a length not shorter than the width of the transfer path of the recording paper 116 and a circular blade 128B which moves along the stationary blade 128A, and the stationary blade 128A is applied to the back side of the recording paper 116 and the circular blade 128B is opposed to the stationary blade 128A with the transfer path of the recording paper 116 intervening therebetween. In the system using cut papers, the cutter 128 is unnecessary.

The decurled and cut recording paper 116 is fed to the suction belt transfer portion 122. The suction belt transfer portion 122 comprises a pair of rollers 131 and 132 and an endless belt 133 passed around the rollers 131 and 132, and at least a part thereof opposed to the nozzle surface and a sensor surface of the print detecting portion 124 of the printing portion 102 is flat.

The belt 133 has a width larger than the width of the recording paper 116 and a number of suction holes (not shown) are formed in the surface of the belt 133. A suction chamber 134 is provided in a position opposed to the nozzle surface and a sensor surface of the print detecting portion 124 of the printing portion 102 inside the belt 133 passed around the rollers 131 and 132, and the recording paper 116 is suctioned and held against the belt 133 by sucking the suction chamber 134 to a negative pressure by a fan 135.

When driving force of a motor (not shown) is transmitted to at least one of the rollers 131 and 132 around which the belt 133 is passed, the belt 133 is driven in the clockwise direction in Figure 6 and the recording paper 116 held on the belt 133 is transferred from the left to the right in Figure 6.

When edgeless prints or the like are printed, ink adheres to the belt 133. Accordingly, a belt cleaning portion 136 is provided to be opposed to the outer side of the belt 133 in a predetermined position (a suitable position outside the printing area).

On the transfer path of the recording paper 116 formed by the suction belt transfer portion 122, a heating fan 140 is provided upstream of the printing portion 102. The heating fan 140 blows heated air to the recording paper 116 before printing to heat the recording paper 116. When the recording paper 116 is heated immediately before printing, ink is apt to be dried after adhering to the recording paper 116.

The ink jet recording system 100 has a so-called full-line type head where the printing portion 102 forms a line type head with a length corresponding to a maximum paper width which is disposed in perpendicular to the paper-feed direction. (See Figure 7) Each of the heads 3K, 3C, 3M and 3Y is formed by a line type head where a plurality of ink discharge ports (nozzle) are arranged over a length exceeding at least one side of a maximum recording paper 116 that is an object of the ink jet recording system 100.

Along the transfer path of the recording paper 116, the heads 3K, 3C, 3M and 3Y corresponding to the inks which are black (K), cyan (C) magenta (M) and yellow (Y) in color are disposed in this order from the upstream. A color image is recorded on the recording paper 116 by discharging the ink from the respective heads 3K, 3C, 3M and 3Y while transferring the recording paper 116.

The print detecting portion 124 comprises a line sensor or the like for taking an image of a result of droplet-shooting by the printing portion 102, and detects a discharge defect such as clogging in the nozzle from a droplet-shooting image read by the line sensor.

Behind the print detecting portion 124, is provided an after drying portion 142 which comprises a heating fan or the like for drying the printed image. Since contact with the printed surface before the ink after printing is dried is preferably avoided, the system where heated air is blown is preferable.

Behind the after drying portion 142, is provided an heating/pressing portion 144 for controlling the glossiness of the image surface. In the heating/pressing portion 144, surface irregularities are transferred to the image surface by pressing the image surface with pressing rollers 145 having predetermined surface irregularities on their surfaces while heating the image surface.

The printings thus obtained are discharged by the paper discharge portion 126. Originally, it is preferred that the running image (image obtained by printing a target image) to be printed be discharged separately from the test printings. In the ink jet recording system 100, a selecting means (not shown) is provided to separate the running image and the test printings and switches running paths and to feed the running image and the test printings to the respective paper discharge portions 126A and 126B.

When the running image and the test printings are simultaneously printed on a larger recording paper 116 in parallel, a cutter 148 is provided to sever the test printings.

The ink jet recording system 100 is arranged as described above.

(Examples)

Embodiments of the present invention and comparative examples will be described, hereinbelow.

(Embodiment 1)

A commercially available sputtering system was prepared, and five rings 250a of stainless steel (SUS) which were 130mm in the inner diameter, 180mm in the outer diameter, and 1mm in thickness was installed at the grounded potential by a target T of 120mm in diameter, thereby obtaining a film-forming system of the first embodiment described above. The rings 250a are laminated by way of conductive spacers 250b which were 10mm in diameter, 5mm in thickness, and like a post in shape. Since the spacer 250b is sufficiently small as compared with the ring 250a, gas G introduced into the vacuum chamber 210 can easily reach the target T passing through the spaces 204 of the rings 250a without affected by the spacers 250b.

As the target T, PZT which was Pb:Zr:Ti (mol ratio)=1.3:0.52:0.48 was employed. The distance between the substrate B and the target T was 60mm and under the conditions in a mixed atmosphere of Ar/$O_2$ where the degree of vacuum was 0.5Pa (the volume fraction of $O_2$ was 2.5%), 700W was imparted to the RF power source. When the plasma potential Vs and the floating potential Vf generated under these conditions were measured, Vs=38V and Vf=16V (Vs-Vf=22eV).

Further, a similar measurement was carried out as the number of the rings 250a was changed between 0 to 4. Figure 8 shows the relation between the number of the rings 250a and Vs-Vf.

When no ring exists, Vs-Vf=43eV. As the number of the rings 250a increments by 1, the potential difference is reduced and when two rings exist, Vs-Vf=33eV while when five rings exist, Vs-Vf=22eV. It has been proved that as the number of rings 250a is increased, Vs-Vf is thus reduced and Vs-Vf can be controlled by changing the number of rings 250a.

(Embodiment 2)

By the use of the film-forming system of the embodiment 1 where the number of the rings 250a was five, PZT film was formed under the film-forming condition of the embodiment 1 (Vs-Vf=22eV). A Ti close contact layer 30$\mu$m thick and an Ir lower electrode 150nm thick were formed on a Si wafer in sequence, thereby preparing a substrate with electrode as a film-forming substrate. The piezoelectric films were formed with the film-forming temperature of 450°C for about 1 hour. The thicknesses of the obtained piezoelectric films were 5$\mu$m. When X-ray diffraction analysis (XRD) was carried on each obtained piezoelectric film, each film was of an excellent perovskite structure having orientation preferentially oriented to a (100) face. The piezoelectric constant $d_{31}$ of the obtained film was about 850.

When the substrate was changed and the film was formed in the similar manner five times, the obtained pieces of film were the same in their performance. This meant that the function of the shield 250 was not deteriorated even after the repeated use.

(Comparative example 1)

PZT film was formed in the manner as the embodiment 2 (Vs-Vf=38eV) except that the rings 250a were all removed. XRD measurement carried on the obtained films has revealed that the obtained films were of a pyrochlore structure where no perovskite crystal exists.

(Comparative example 2)

By the use of the same vacuum chamber as in the embodiment 1, a cylindrical shield of stainless steel (SUS) which were 130mmφ in the inner diameter, and 24mm in the height was installed on the grounded member 202 to surround a target T in place of the above shield 250, thereby forming a grounded potential. When PZT film was formed in the same manner as the embodiment 2, each film was of an excellent perovskite structure having orientation preferentially oriented to a (100) face as in the embodiment 2.

However, when the substrate was changed and the film was formed in the similar manner five times, the fifth pieces of obtained film was of a pyrochlore structure and did not have desired characteristics. This meant that the function of the shield having no space was deteriorated after the repeated use. It is conceivable that since the shield of comparative example 2 was a cylindrical shield with no space, particles of the elements Tp of the target T covers the inner surface of the shield to deteriorate the function thereof as a shield.

The film-forming system and the film-forming process of the present invention are applicable when the film is to be grown by a vapor phase growth method using plasma, and are applicable to piezoelectric film for use in, for instance, an ink jet recording heads, ferroelectric memories (FRAM), and a pressure sensor.

## Claims

1. A film forming system (200, 300) comprising a vacuum chamber (210, 310) which enables film-forming gas (G) to be introduced thereinto and discharged therefrom, a target holder (12) which is disposed in the vacuum chamber (210, 310) to hold a target (T), a substrate holder (11) which is opposed to the target holder (12) and holds a film-forming substrate (B) on which film is formed, a plasma forming portion which generates plasma space (P) between the target holder (12) and the film-forming substrate (B), and a shield (250) which surrounds the outer peripheral surface of the target holder (12) facing the substrate (B),
the shield (250) comprising a plurality of shield layers (250a) laminated with each other,
the dimension L of each of the shield layers (250a) of the shield (250) in a direction perpendicular to a laminating direction is not smaller than a distance S between the shield layers in the laminating direction (L ≥ S), wherein the shield layers (250a) are laminated with each other intervening therebetween a space (204) which permits the film-forming gas (G) to pass therethrough, and wherein the number of the shield layers (250a) is changeable in order to control the difference Vs-Vf (V) between the plasma potential Vs(V) during forming a film and the floating potential Vf(V) of the substrate (B).

2. A film forming system as defined in claim 1, in which the shield (250) is grounded.

3. A film forming system as defined in claim 1 or 2, in which the shield (250) is electrically insulated from the target (T) and the wall of the vacuum chamber (210), 310) while a voltage is imparted to the target.

4. A film forming system as defined in any of claims 1 to 3, in which a gas introduction tube (214) and a gas discharge tube (15) are mounted on the vacuum chamber at about the same height as the shield (250).

5. A film forming system as defined in claim 4, wherein the gas introduction tube and the gas discharge tube are disposed opposite to each other.

6. A process of forming film of elements of a target (T) on a substrate (B) spaced from the target (T) by a vapor phase growth method using plasma, comprising providing a shield (250) having shield layers (250a) surrounding the outer peripheral surface of the target (T) facing the substrate (B) to overlap at least one other shield layer with a space in a vertical direction in non-contact with the target (T), and controlling the difference Vs-Vf (V) between the plasma potential Vs (V) and the floating potential Vf (V) of the substrate (B) by the shield comprising a changeable number of shield layers (250a) while forming the film.

7. A film-forming process as defined in claim 6, in which a film is formed with the difference Vs-Vf (V) between the plasma potential Vs (v) and the floating potential Vf (V) of the substrate (B) controlled by adjusting the height of the shield (250).

8. A film-forming process as defined in claim 6 or 7, in which the piezoelectric film (40) is formed with the difference Vs-Vf (V) between the plasma potential Vs (v) and the floating potential Vf (V) of the substrate (B) held not larger than 35V and the temperature of the substrate not lower than 400 °C.

9. Making use of the film-forming process as defined in any one of claims 6 to 8 for forming an insulated film.

10. Making use of the film-forming process as defined in any one of claims 6 to 8 for forming a dielectric film.

11. Making use of the film-forming process as defined in any one of claims 6 to 8 for forming a piezoelectric film.

12. Making use of the film-forming process as defined in any one of claims 6 to 8 for forming a ferrodielectric film.

**Patentansprüche**

1. Schichterzeugungssystem (200, 300), umfassend eine Vakuumkammer (210, 310), die es ermöglicht, dass ein Schichterzeugungsgas (G) in sie eingeleitet und aus ihr ausgetragen wird, einen Targethalter (12) der sich in der Vakuumkammer (210, 310) befindet, um ein Target (T) zu halten, einen Substrathalter (11), der dem Targethalter (12) gegenüber liegt und ein Schichterzeugungssubstrat (B) hält, auf der eine Schicht gebildet wird, einen Plasmaerzeugungsteil, der einen Plasmaraum (P) zwischen dem Targethalter (12) und dem Schichterzeugungssubstrat (B) erzeugt, und eine Abschirmumg (250), die die Außenumfangsfläche des Targethalters (12) gegenüber dem Substrat (B) umgibt,
wobei die Abschirmung (250) eine Mehrzahl von Abschirmungsschichten (250a) aufweist, die miteinander geschichtet sind,
die Abmessung L jeder der Abschirmungsschichten (250a) der Abschirmung (250) in einer Richtung rechtwinklig zu der Schichtungsrichtung nicht kleiner ist als ein Abstand S zwischen den Abschirmungsschichten in Schichtungsrichtung (L ≥ S), wobei die Abschirmungsschichten (250a) derart miteinander geschichtet sind, dass zwischen ihnen jeweils ein Raum (204) vorhanden ist, der das Durchströmen des Schichterzeugungsgases (G) ermöglicht, und wobei die Anzahl der Abschirmungsschichten (250a) änderbar ist, um die Differenz Vs-Vf (V) zwischen dem Plasmapotenzial Vs(V) während der Erzeugung einer Schicht und dem Floating-Potenzial Vf(V) des Substrats (B) zu steuern.

2. Schichterzeugungssystem nach Anspruch 1, bei dem die Abschirmung (250) geerdet ist.

3. Schichterzeugungssystem nach Anspruch 1 oder 2, bei dem die Abschirmung (250) elektronisch von dem Target (I) und der Wand der Vakuumkammer (210, 310) elektrisch isoliert ist, während eine Spannung an das Target gelegt wird.

4. Schichterzeugungssystem nach einem der Ansprüche 1 bis 3, bei dem an der Vakuumkammer etwa in der Höhe der Abschirmung (250) eine Gaseinleitleitung (214) und eine Gasaustragleitung (15) angebracht sind.

5. Schichterzeugungssystem nach Anspruch 4, bei dem die Gaseinleitleitung und die Gasaustragleitung einander gegenüberliegend angeordnet sind.

6. Verfahren zur Schichterzeugung aus Elementen eines Targets (T) auf einem von dem Target (T) beabstandeten Substrat (B) durch Wachstum aus der Dampfphase unter Einsatz von Plasma, umfassend das Bereitstellen einer Abschirmung (250) mit Abschirmungsschichten (250a), die die Außenumfangsfläche des Targets (T) gegenüber dem Substrat (B) umgeben, um mindestens eine weitere Abschirmungsschicht mit einem Abstand in vertikaler Richtung und ohne Berührung des Targets (T) zu überlappen, und Steuern der Differenz Vs-Vf (V) zwischen dem Plasmapotenzial Vs (V) und dem Floating-Potenzial Vf (V) des Substrats (B) durch die Abschirmung, welche eine änderbare Anzahl von Abschirmungsschichten (250a) während der Erzeugung der Schicht aufweist.

7. Schichterzeugungsverfahren nach Anspruch 6, bei dem eine Schicht erzeugt wird, wobei die Differenz Vs-Vf (V) zwischen dem Plasmapotenzial Vs (v) und dem Floating-Potenzial Vf (V) des Substrats (B) durch Justieren der Höhe der Abschirmung (250) gesteuert wird.

8. Schichterzeugungsverfahren nach Anspruch 6 oder 7, bei dem die piezoelektrische Schicht (40) erzeugt wird, während die Differenz Vs-Vf (V) zwischen dem Plasmapotenzial Vs (v) und dem Floating-Potenzial Vf (V) des Substrats (B) auf einem Wert von nicht mehr als 35 V gehalten wird und die Temperatur des Substrats nicht niedriger ist als 400 °C.

**9.** Verwendung des Schichterzeugungsverfahrens nach einem der Ansprüche 6 bis 8 zur Bildung einer Isolierschicht.

**10.** Verwendung des Schichterzeugungsverfahrens nach einem der Ansprüche 6 bis 8 zum Erzeugen einer dielektrischen Schicht.

**11.** Verwendung des Schichterzeugungsverfahrens nach einem der Ansprüche 6 bis 8 zum Erzeugen einer piezoelektrischen Schicht.

**12.** Verwendung des Schichterzeugungsprozesses nach einem der Ansprüche 6 bis 8 zum Erzeugen einer ferrodielektrischen Schicht.

**Revendications**

**1.** Système de formation d'un film (200, 300) comprenant une chambre à vide (210, 310) permettant l'introduction d'un gaz de formation de film (G) vers celui-ci et son évacuation hors de celui-ci, un support de cible (12) disposé dans la chambre à vide (210, 310) afin de maintenir une cible (T), un support de substrat (11) qui est en face du support de cible (12) et maintient un substrat de formation de film (B) sur lequel est formé un film, une partie de formation de plasma qui génère un espace de plasma (P) entre le support de cible (12) et le substrat de formation de film (B), et un écran (250) qui entoure la surface périphérique extérieure du support de cible (12) faisant face au substrat (B), l'écran (250) comprenant une pluralité de couches formant écran (250a) stratifiées les unes avec les autres ; la dimension L de chacune des couches formant écran (250a) de l'écran (250) dans une direction perpendiculaire à une direction de stratification n'est pas inférieure à une distance S entre les couches formant écran dans la direction de stratification ($L \geq S$), dans lequel les couches formant écran (250a) sont stratifiées les unes avec les autres, avec l'intervention d'un espace (204) entre elles permettant au gaz de formation de film (G) de les traverser, et dans lequel le nombre de couches formant écran (250a) peut être modifié afin de contrôler la différence Vs-Vf(V) entre le potentiel de plasma Vs(V) durant la formation d'un film et le potentiel flottant Vf(V) du substrat (B).

**2.** Système de formation de film selon la revendication 1, dans lequel l'écran (250) est relié à la terre.

**3.** Système de formation de film selon la revendication 1 ou 2, dans lequel l'écran (250) est isolé sur le plan électrique de la cible (T) et de la paroi de la chambre à vide (210, 310) tandis qu'une tension est appliquée à la cible.

**4.** Système de formation de film selon l'une quelconque des revendications 1 à 3, dans lequel un tube d'introduction de gaz (214) et un tube d'évacuation de gaz (15) sont montés sur la chambre à vide environ à la même hauteur que l'écran (250).

**5.** Système de formation de film selon la revendication 4, dans lequel le tube d'introduction de gaz et le tube d'évacuation de gaz sont disposés l'un en face de l'autre.

**6.** Procédé de formation de film d'éléments d'une cible (T) sur un substrat (B) espacé de la cible (T) par un procédé de croissance en phase vapeur utilisant du plasma, comprenant la fourniture d'un écran (250) présentant des couches formant écran (250a) entourant la surface périphérique extérieure de la cible (T) faisant face au substrat (B), afin de présenter un chevauchement avec au moins une autre couche formant écran avec un espace dans une direction verticale sans contact avec la cible (T), et le contrôle de la différence Vs-Vf(V) entre le potentiel de plasma Vs(V) et le potentiel flottant Vf(V) du substrat (B) par l'écran comprenant un nombre pouvant être modifié de couches formant écran (250a) lors de la formation du film.

**7.** Procédé de formation de film selon la revendication 6, dans lequel un film est formé avec la différence Vs-Vf(V) entre le potentiel de plasma Vs(v) et le potentiel flottant Vf(v) du substrat (B) contrôlé en réglant la hauteur de l'écran (250).

**8.** Système de formation de film selon la revendication 6 ou 7, dans lequel le film piézoélectrique (40) est formé avec la différence Vs-Vf(V) entre le potentiel de plasma Vs(v) et le potentiel flottant Vf(v) du substrat (B) maintenu de manière à ne pas être supérieur à 35V et avec la température du substrat non inférieure à 400 °C.

**9.** Utilisation du système de formation de film selon l'une quelconque des revendications 6 à 8 en vue de former un film isolé.

**10.** Utilisation du système de formation de film selon l'une quelconque des revendications 6 à 8 en vue de former un film diélectrique.

**11.** Utilisation du système de formation de film selon l'une quelconque des revendications 6 à 8 en vue de former un film piézoélectrique.

**12.** Utilisation du système de formation de film selon l'une quelconque des revendications 6 à 8 en vue de former un film ferrodiélectrique.

# FIG.1A

# FIG.1B

# FIG.2

# FIG.3

# FIG.4

# FIG.5

# FIG.6

EP 2 261 948 B1

# FIG.7

102

3K  3C  3M  3Y

116  133

131  124  132

# FIG.8

Vs–Vf(eV)

50

40

30

20

10

0

0    1    2    3    4    5    6

NUMBER OF RINGS (FIN)

**REFERENCES CITED IN THE DESCRIPTION**

**Patent documents cited in the description**

- JP 2000290771 A
- JP 2005272941 A

- US 3864239 A